# EUROPEAN PATENT SPECIFICATION

(11) **EP 0 534 355 B1**
(45) Date of publication and mention of the grant of the patent: **10.04.1996**
(21) Application number: 92116158.4
(22) Date of filing: 21.09.1992
(51) Int. Cl.: H03H 3/08

(54) **Method of manufacturing a surface acoustic wave device**
Herstellungsverfahren für akustische Oberflächenwellenanordnungen
Procédé de fabrication de dispositif à ondes acoustiques de surface

(30) Priority: 24.09.1991 JP 242974/91
(43) Date of publication of application: 31.03.1993
(73) Proprietor: SUMITOMO ELECTRIC INDUSTRIES, LIMITED, Osaka 541 (JP)
(72) Inventor: Nakahata, Hideaki, c/o Itami Works of Sumitomo, Itami-shi, Hyogo (JP); Shikata, Shinichi, c/o Itami Works of Sumitomo, Itami-shi, Hyogo (JP); Hachigo, Akihiro, c/o Itami Works of Sumitomo, Itami-shi, Hyogo (JP); Fujimori, Naoji, c/o Itami Works of Sumitomo, Itami-shi, Hyogo (JP)
(74) Representative: Herrmann-Trentepohl, Werner, Dipl.-Ing.

(56) References cited:
- US-A- 4 952 832
- PATENT ABSTRACTS OF JAPAN vol. 015, no. 461 (C-0887)22 November 1991

## Description

### BACKGROUND OF THE INVENTION

### Field of the Invention

The present invention relates to a method of manufacturing a surface acoustic wave device used in a high frequency range.

### Description of the Background Art

A surface acoustic wave device utilizing surface acoustic waves propagated on the surface of a solid body with energies being concentrated thereon can be miniaturized with stable performance, and therefore it is used as an intermediate frequency filter of a TV receiver and so on. The surface acoustic wave device includes interdigital electrodes provided on a piezoelectric layer. When an AC electric field is applied to the interdigital electrodes on the piezoelectric layer of the surface acoustic wave device having such structure, strains having opposite faces to each other are generated between adjacent electrodes by the piezoelectric effect, and surface waves are excited. Bulk single crystal of quartz, LiNbO, LiTaO or the like, and a ZnO thin film vapor deposited on a substrate are used as the materials of the piezoelectric body.

The operation frequency f of the surface acoustic wave device is determined as f = v/λ (v: phase velocity of the acoustic wave propagating over the surface of the solid body, λ: pitch of the interdigital electrodes). More specifically, it can be used in higher frequency range when the pitch λ is smaller and the velocity v is larger. However, the velocity v of the surface acoustic wave is limited by the material characteristics of the solid body. Because of the technical limit of fine processing (the smallest possible rule of processing in photolithography is 0.8µm, while electronic beam exposure technique enables processing in the order of submicrons: however, the yield becomes lower as the line width becomes thinner), there is a lower limit of the pitch of the interdigital electrodes. Accordingly, the highest possible operation frequency of the practically used surface acousting wave device at present is 900MHz.

A surface acoustic wave device which can be used in higher frequency range (GHz range) has been desired, as communications at higher frequencies such as satellite communication and mobile communication have been developed. Diamond has the highest sound velocity among all materials known so far (the velocity of the transverse wave = 13000m/s, the velocity of the longitudinal wave = 16000m/s) and if diamond is used as a base material, the velocity of the surface acoustic wave can be made 10000m/s or higher. A diamond-like carbon film has similar sound velocity as diamond, and the velocity v of the surface acoustic wave can be increased to the same extent when it is used as the base material. Surface acoustic wave devices having stacked structure of diamond and a piezoelectric body are disclosed, for example, in Japanese Patent Laying-Open Nos. 64-20714 and 64-62911 (see also US-A 4952832), and developments of such devices have been promoted.

The nature of the piezoelectric layer largely effects the characteristics of the surface acoustic wave device. A specific example of a surface acoustic wave device formed by providing a ZnO film, which is a piezoelectric material, on diamond will be described. Conventionally, the ZnO film has been formed on the diamond by high frequency sputtering method. In a surface acoustic wave device, the efficiency of excitation of the surface acoustic waves and propagation loss of the waves are influenced by the c-axis orientation, grain size, surface flatness, resistivity and adhesiveness of the film on the diamond substrate.

If the c-axis orientation of the formed ZnO film is not sufficient, piezoelectric nature of the ZnO film is not fully exhibited, and the surface acoustic waves are not excited. The smaller σ value of the film in accordance with the X-ray rocking curve analysis of c-axis orientation is the more preferable. The value must be within 5 degrees, in order to use the device as the surface acoustic wave device. Generally, the σ value of the ZnO film formed on the diamond substrate by RF sputtering method is in the range of 2 to 3 degrees.

The smaller the grain size of the formed ZnO film is, the better the surface flatness, and the smaller becomes the propagation loss of the surface acoustic waves when the surface is more flat. If the propagation loss is too large, loss in the device becomes larger and the device cannot be practically used. Namely, the surface of the film should be as flat as possible. The ZnO film formed on the diamond substrate by RF sputtering having the σ value of about 2 to 3 degrees would have the film thickness of 1µm and the grain size of 50nm, and corresponding surface roughness is up to about several tens nm.

The piezoelectric film must have high resistivity to excite the surface acoustic waves. The composition ratio of Zn and O of the ZnO film formed by the RF sputtering method is not 1:1 but Zn is excessive. Accordingly, the film turns to be an n type semiconductor, which is conductive. In order to make this film have the high resistivity, Li has been doped in the ZnO during sputtering to compensate for the charges and to increase resistivity of the film. The resistivity of the c-axis oriented ZnO film with Li doped during RF sputtering can generally be adjusted at about 10⁶Ω·cm.

As described above, the ZnO polycrystalline film having superior c-axis orientation formed on a diamond layer by the conventional RF sputtering method has the film thickness of 1µm and the grain size of about 50nm. Further, since the ZnO film is doped with Li impurities to provide higher resistivity, the film is imperfect in crystallinity. Therefore, when the surface acoustic wave device is fabricated by using the ZnO film thus formed by the RF sputtering method, propagation loss of the surface acoustic waves comes to be large (about 70dB/cm at 1GHz). This causes large insertion loss between the input and output of the device, which leads to limited application. The problem of larger propagation loss is more conspicuous as the frequency of the device at which it is used becomes higher.

### SUMMARY OF THE INVENTION

An object of the present invention is to provide a method of manufacturing a surface acoustic wave device the insertion loss of which is small in a high frequency range.

According to one aspect, the present invention provides a method of manufacturing a surface acoustic wave device including a substrate, a diamond layer formed on the substrate, a piezoelectric layer formed on the diamond layer, and electrodes formed on any of the substrate, the diamond layer and the piezoelectric layer, in which the piezoelectric layer is formed by laser ablation method.

According to another aspect, the present invention provides a method of manufacturing a surface acoustic wave device including the steps of forming a diamond layer on a substrate, forming electrodes on the diamond layer, and forming a piezoelectric layer by laser ablation method on the diamond layer and on the electrodes.

The temperature of the stacked body including the substrate and the diamond layer when the piezoelectric layer is formed by the laser ablation method is preferably in the range from 150°C to 500°C, and more preferably, from 200°C to 350°C.

The film forming atmosphere gas when the piezoelectric layer is formed by the laser ablation method should preferably be oxygen.

The pressure of the film forming atmosphere gas when the piezoelectric layer is formed by the laser ablation method is preferably in the range of 1 x 10⁻³Pa to 5 x 10⁻¹ Pa, and more preferably, from 5 x 10⁻³Pa to 1 x 10⁻¹Pa.

In the present invention, the piezoelectric layer is mainly composed of at least one compound selected from the group consisting of ZnO, AlN, Pb (Zr, Ti)O₃, (Pb, La) (Zr, Ti)O₃, LiTaO₃, LiNbO₃, SiO₂, Ta₂O₅, Nb₂O₅, BeO, Li₂B₄O₇, KNbO₃, ZnS, ZnSe and CdS.

The laser ablation method is a method of forming a film on a substrate in which pulse laser is focused and irradiated on a target to generate ions, atoms, and clusters (which method is described in, e.g., Solid State Technology / February 1989, pp. 106-110). According to the present invention, by using the laser ablation method when the ZnO film is formed on the diamond substrate, a ZnO film having not only superior c-axis orientation but also smaller grain size (the grain size of 10nm with the film thickness of 1µm), superior surface flatness (the surface roughness is 10nm at the largest) and resistivity as high as about 10⁶Ω·cm, which resistivity can be attained without doping Li which was necessary in the conventional RF sputtering method, can be formed.

The film forming conditions when the piezoelectric layer is formed by the laser ablation method is as follows.

Excimer laser, YAG laser, CO₂ laser or the like is preferred as the laser beam. A preferred target includes a sintered ceramics of ZnO and other Zn compounds.

Oxygen is preferred as the atmosphere gas at film formation. Inert gas such as Ar, or CO₂ may possibly be used. However, when the resistivities of the resulting ZnO films are compared, a ZnO film having superior insulation of about 10⁶ to 10¹⁰ Ω·cm can be provided when oxygen is used, while ZnO film having poor insulation of about 10⁴ to 10⁶ Ω·cm results in when the latter gases are used. If N₂ is used as the atmosphere gas, the resistivity of the resulting ZnO film is about 10 to 10⁴Ω·cm which is too low to be used as the surface acoustic wave device.

A ZnO film having superior orientation and surface flatness can be provided if the pressure of the film forming atmosphere gas is within the range of 1 x 10⁻³Pa to 5 x 10⁻¹Pa. More preferable range is from 5 x 10⁻³Pa to 1 x 10⁻¹Pa to provide a ZnO film having good uniformity (film thickness distribution < 10%).

The temperature of the stacked body including the substrate and the diamond layer should preferably be in the range from 150°C to 500°C. If the temperature is lower than 150°C, the ZnO film would have inferior orientation (σ value > 4°), and when the temperature is higher than 500°C, the ZnO film would have large grain size, causing larger surface roughness (of more than 30nm). More preferably, the temperature should be within the range from 200°C to 350°C, which provides a ZnO film having superior orientation of σ < 3° and superior flatness of surface roughness < 20nm.

By the stacked structure of the ZnO film and diamond, the propagation loss of the surface acoustic wave can be made small (20dB/cm at 1GHz). By using the laser ablation method under the above described conditions when the ZnO film is to be formed, a surface acoustic wave device having smaller insertion loss can be fabricated, as compared with the conventional RF sputtering method.

Accordingly, the surface acoustic wave device manufactured by the present invention can be used as a frequency filter, a resonator, a delay liner a convolver, a correlator or the like, since the insertion loss in the range of several hundreds of MHz to GHz is small.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a cross sectional view showing a structure of a surface acoustic wave device in accordance with one embodiment of the present invention.

Fig. 2 is a cross sectional view showing various arrangements of electrodes of the surface acoustic wave device in accordance with another embodiment of the present invention.

### DESCRIPTION OF THE PREFERRED EMBODIMENTS

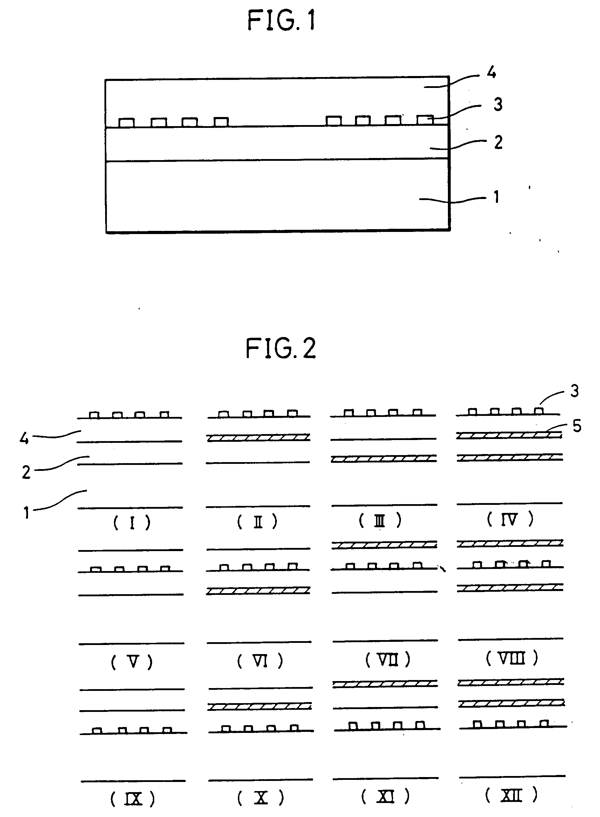

A surface acoustic wave filter having the structure shown in Fig. 1 was fabricated. A polycrystalline diamond layer 2 was formed by microwave plasma CVD method with H₂ and CH₄ used as a material gas on a Si substrate 1. After surface grinding, two pairs (for input and output) of Al interdigital electrodes 3 (line width:2µm, pitch:600µm, number of pairs:50 pairs, propagation distance:500µm) were formed. A ZnO film 4 having the thickness of 1µm was formed thereon by the laser ablation method. The conditions for film formation were: substrate temperature:300°C, used laser:excimer laser, laser intensity:2J/cm, film forming atmosphere oxygen 4 x 10⁻Pa, target material:ZnO ceramics.

The c-axis orientation of the ZnO film was as good as σ = 1.0 degree, the grain size was 10nm, the surface flatness was several to 10 nm and the resistivity was 10⁶Ω·cm. The frequency characteristic of the surface acoustic wave filter formed in this manner was measured. The characteristic of the bandpass filter with the surface acoustic wave of the primary mode corresponds to the characteristic of the bandpass filter with the central frequency of 1Ghz, and the insertion loss at the central frequency was 10dB.

### Example for comparison

A ZnO film was formed by the RF sputtering method and a surface acoustic wave filter having the similar structure as the above embodiment was fabricated. The conditions of sputtering were: RF power:150W, gas Ar50%, oxygen 50%, pressure:1.3Pa, substrate temperature:300°C, target material:ceramics of ZnO+1% of Li₂CO₃. The c-axis orientation of the ZnO film was σ = 2.5 degrees, grain size was 50nm, surface flatness was up to 30nm, and the resistivity was 10⁶Ω·cm. As to the frequency characteristics of the surface acoustic wave filter, the central frequency was 1GHz and the instruction loss was 25dB.

In the embodiment of the surface acoustic wave device manufactured in accordance with the present invention, counter-electrodes 5 may be provided for enlarging the propagation velocity of the surface acoustic waves propagating over the stacked structure and to enlarge the electromechanical coupling coefficient. Fig. 2 is a cross sectional view showing various electrode arrangements. The effects of the present invention can be obtained in any of the surface acoustic wave devices having such electrode arrangements as shown in Fig. 2.

Although the present invention has been described and illustrated in detail, it is clearly understood that the same is by way of illustration and example only and is not to be taken by way of limitation, the scope of the present invention being limited only by the terms of the appended claims.

## Claims

1. A method of manufacturing a surface acoustic wave device including a substrate, a diamond layer formed on the substrate, a piezoelectric layer formed on the diamond layer, and electrodes formed on any of said substrate, said diamond layer and said piezoelectric layer, wherein
said piezoelectric layer is formed by laser ablation method.

2. The method of manufacturing a surface acoustic wave device comprising the steps of:
forming a diamond layer on a substrate;
forming electrodes on said diamond layer; and
forming a piezoelectric layer on said diamond layer and on said electrodes by laser ablation method.

3. The method of manufacturing a surface acoustic wave device according to claim 1 or 2, wherein
temperature of a stacked body of the substrate and the diamond layer when the piezoelectric layer is formed by the laser ablation method is in the range of 150°C to 500°C.

4. The method of manufacturing a surface acoustic wave device according to claim 1 or 2, wherein
temperature of a stacked body of the substrate and the diamond layer when the piezoelectric layer is formed by the laser ablation method is preferably in the range of 200°C to 350°C.

5. The method of manufacturing a surface acoustic wave device according to claim 1 or 2, wherein
film forming at atmosphere gas when the piezoelectric layer is formed by the laser ablation method is oxygen.

6. The method of manufacturing a surface acoustic wave device according to claim 1 or 2, wherein
pressure of the film forming atmosphere gas when the piezoelectric layer is formed by the laser ablation method is in the range of 1 x 10⁻³Pa to 5 x 10⁻¹Pa.

7. The method of manufacturing a surface acoustic wave device according to claim 1 or 2, wherein
pressure of the film forming atmosphere gas when the piezoelectric layer is formed by the laser ablation method is preferably in the range of 5 x 10⁻³Pa to 1 x 10⁻¹Pa.

8. The method of manufacturing a surface acoustic wave device according to claim 1 or 2, wherein
when the piezoelectric layer is formed by the laser ablation method, temperature of a stacked body of the substrate and the diamond layer is in the range of 150°C to 500°C,
film forming atmosphere gas is oxygen, and
pressure of the film forming atmosphere gas is in the range of 1 x 10⁻³Pa to 5 x 10⁻¹Pa.

9. The method of manufacturing a surface acoustic wave device according to claim 1, wherein
said piezoelectric layer is mainly composed of at least one component selected from the group consisting of ZnO, AlN, Pb (Zr, Ti)O₃, (Pb, La) (Zr, Ti)O₃, LiTaO₃, LiNbO₃, SiO₂, Ta₂O₅ , Nb₂O₅, BeO, Li₂B₄O₇, KNbO₃, ZnS, ZnSe and CdS.

## Patentansprüche

1. Herstellungsverfahren für akustische Oberflächenwellenanordnungen, welches ein Substrat, eine auf dem Substrat gebildete Diamantschicht , eine auf der Diamantschicht gebildete piezoelektrische Schicht, und Elektroden aufweist, die auf dem Substrat, der Diamantschicht oder der piezoelektrischen Schicht gebildet sind, wo-rin die piezoelektrische Schicht durch ein Laserablations-verfahren gebildet wird.

2. Herstellungsverfahren für akustische Oberflächenwellenanordnungen umfassend die Schritte:
Bildung einer Diamantschicht auf einem Substrat;
Bildung von Elektroden auf der Diamantschicht; und
Bildung einer piezoelektrischen Schicht auf der Diamantschicht und auf den Elektroden durch ein Laserablations-verfahren.

3. Herstellungsverfahren für akustische Oberflächenwellenanordnungen gemäß Anspruch 1 oder 2, worin die Temperatur eines geschichteten Körpers aus dem Substrat und der Diamantschicht in dem Bereich von 150°C bis 500°C ist, wenn die piezoelektrische Schicht durch das Laserablationsverfahren gebildet wird.

4. Herstellungsverfahren für akustische Oberflächenwellenanordnungen gemäß Anspruch 1 oder 2, worin die Temperatur eines geschichteten Körpers aus dem Substrat und der Diamantschicht bevorzugt im Bereich von 200°C bis 350°C ist, wenn die piezoelektrische Schicht durch das Laserablationsverfahren gebildet wird.

5. Herstellungsverfahren für akustische Oberflächenwellenanordnungen gemäß Anspruch 1 oder 2, worin das Filmbildungsatmosphärengas Sauerstoff ist, wenn die piezoelektrische Schicht durch das Laserablationsverfahren gebildet wird.

6. Herstellungsverfahren für akustische Oberflächenwellenanordnungen gemäß Anspruch 1 oder 2, worin der Druck des Filmbildungsatmosphärengases in dem Bereich von 1 x 10⁻³ Pa bis 5 x 10⁻¹ Pa ist, wenn die piezoelektrische Schicht durch das Laserablationsverfahren gebildet wird.

7. Herstellungsverfahren für akustische Oberflächenwellenanordnungen gemäß Anspruch 1 oder 2, worin der Druck des Filmbildungsatmosphärengases bevorzugt in dem Bereich von 5 x 10⁻³ Pa bis 1 x 10⁻¹ Pa ist, wenn die piezoelektrische Schicht durch das Laserablationsverfahren gebildet wird.

8. Herstellungsverfahren für akustische Oberflächenwellenanordnungen gemäß Anspruch 1 oder 2, worin die Temperatur eines geschichteten Körpers aus dem Substrat und der Diamantschicht im dem Bereich von 150°C bis 500°C ist, wenn die piezoelektrische Schicht durch das Laserablationsverfahren hergestellt wird,
das Filmbildungsatmosphärengas Sauerstoff ist und
der Druck des Filmbildungsatmosphärengases in dem Bereich von 1 x 10⁻³ Pa bis 5 x 10⁻¹ Pa ist.

9. Herstellungsverfahren für akustische Oberflächenwellenanordnungen gemäß Anspruch 1, worin die piezoelektrische Schicht hauptsächlich aus mindestens einer Komponente ausgewählt aus der Gruppe, die aus ZnO, AlN, Pb(Zr, Ti)O₃, (Pb, La) (Zr, Ti)O₃, LiTaO₃, LiNbO₃, SiO₂, Ta₂O₅, Nb₂O₅, BeO, Li₂B₄O₇, KNbO₃, ZnS, ZnSe und CdS besteht, zusammengesetzt ist.

## Revendications

1. Procédé pour la fabrication d'un dispositif à ondes acoustiques de surface comprenant un substrat, une couche de diamant formée sur le substrat, une couche piézoélectrique formée sur la couche de diamant, et des électrodes formées soit sur le substrat, soit sur la couche de diamant et soit sur la couche piézoélectrique, dans lequel
la couche piézoélectrique est formée par le procédé d'ablation au laser.

2. Procédé pour la fabrication d'un dispositif à ondes acoustiques de surface comprenant les étapes consistant à :
former une couche de diamant sur un substrat ;
former des électrodes sur la couche de diamant ; et
former une couche piézoélectrique sur la couche de diamant et sur les électrodes par le procédé d'ablation au laser.

3. Procédé pour la fabrication d'un dispositif à ondes acoustiques de surface selon la revendication 1 ou 2, dans lequel
la température d'un corps empilé du substrat et de la couche de diamant lorsque la couche piézoélectrique est formée par le procédé d'ablation au laser, se situe dans la plage de 150 à 500°C.

4. Procédé pour la fabrication d'un dispositif à ondes acoustiques de surface selon la revendication 1 ou 2, dans lequel
la température du corps empilé du substrat et de la couche de diamant lorsque la couche piézoélectrique est formée par le procédé d'ablation au laser, se situe de préférence dans la plage de 200 à 350°C.

5. Procédé pour la fabrication d'un dispositif à ondes acoustiques de surface selon la revendication 1 ou 2, dans lequel
le gaz atmosphérique pour la formation de la pellicule ou film lorsque la couche piézoélectrique est formée par le procédé d'ablation au laser, est l'oxygène.

6. Procédé pour la fabrication d'un dispositif à ondes acoustiques de surface selon la revendication 1 ou 2, dans lequel
la pression du gaz atmosphérique de formation de film lorsque la couche piézoélectrique est formée par le procédé d'ablation au laser, se situe dans la plage de 1 x 10⁻³ Pa à 5 x 10⁻¹ Pa.

7. Procédé pour la fabrication d'un dispositif à ondes acoustiques de surface selon la revendication 1 ou 2, dans lequel
la pression du gaz atmosphérique de formation de la pellicule lorsque la couche piézoélectrique est formée par le procédé d'ablation au laser, se situe de préférence dans la plage de 5 x 10⁻³ Pa à 1 x 10⁻¹ Pa.

8. Procédé pour la fabrication d'un dispositif à ondes acoustiques de surface selon la revendication 1 ou 2, dans lequel
lorsque la couche piézoélectrique est formée par le procédé d'ablation au laser, la température d'un corps empilé du substrat et de la couche de diamant se situe dans la plage de 150 à 500°C,
le gaz atmosphérique de formation de film est l'oxygène, et
la pression du gaz atmosphérique de formation du film se situe dans la plage de 1 x 10⁻³ Pa à 5 x 10⁻¹ Pa.

9. Procédé pour la fabrication d'un dispositif à ondes acoustiques de surface selon la revendication 1, dans lequel
la couche piézoélectrique est principalement composée d'au moins un composant choisi dans le groupe constitué par ZnO, AlN, Pb (Zr, Ti)O₃, (Pb, La) (Zr, Ti)O₃, LiTaO₃, LiNbO₃, SiO₂, Ta₂O₅, Nb₂O₅, BeO, Li₂B₄O₇, KNbO₃, ZnS, ZnSe et CdS.
